# EUROPÄISCHE PATENTSCHRIFT

(11) **EP 1 111 671 B1**
(45) Veröffentlichungstag und Bekanntmachung des Hinweises auf die Patenterteilung: **26.10.2005**
(21) Anmeldenummer: 00127180.8
(22) Anmeldetag: 12.12.2000
(51) Int. Cl.: H01L 23/31

(54) **Verfahren zum Herstellen einer Halbleiteranordnung**
Process for fabricating a semiconductor device
Procédé de fabrication d'un composant semiconducteur

(30) Priorität: 22.12.1999 DE 19962431
(43) Veröffentlichungstag der Anmeldung: 27.06.2001
(73) Patentinhaber: Micronas GmbH, 79108 Freiburg (DE)
(72) Erfinder: Igel, Günter, Dipl.-Ing., 79331 Teningen (DE)
(74) Vertreter: Patentanwälte Westphal, Mussgnug & Partner

(56) Entgegenhaltungen:
- DE-A- 19 641 777
- US-A- 3 775 200
- US-A- 3 952 404
- US-A- 4 189 342
- US-A- 4 891 334
- US-A- 5 919 713

## Beschreibung

Die Erfindung bezieht sich auf ein Verfahren zum Herstellen einer Halbleiteranordnung, wobei insbesondere ein Wafer mit einer Vielzahl von Chips bildenden Halbleiteranordnungen hergestellt und der Wafer danach zerteilt und dadurch die Halbleiteranordnungen vereinzelt werden, wobei zumindest ein Bereich einer Wafer-Seite während des Ätzens des übrigen Bereiches mittels einer Passivierungsschicht abgedeckt wird und wobei nach dem Ätzen die Passivierungsschicht entfernt wird.

Aus der DE 196 50 821 A1 ist es bereits bekannt, Bereiche einer Siliziumplatte mit einer Passivierungsschicht zu versehen, um diese Bereiche gegenüber einem Ätzmittel zu schützen. Dabei wird der zu schützende Bereich mit einer Beschichtung versehen, die einen überwiegenden Anteil von Benzocyclobuten aufweist. Weiterhin kann zusätzlich ein Haftvermittler aus Aminopropylsilan vorgesehen sein. Nach dem Ätzen der außerhalb der Passivierungsschicht liegenden Bereiche wird die Passivierungsschicht entfernt, was mit Hilfe eines Lösemittels, insbesondere Salpetersäure erfolgt. Alternativ kann die Passivierungsschicht auch mit einem Sauerstoffplasma beaufschlagt und entfernt werden.

Der Einsatz von Lösungsmittel ist aus Umweltschutzgründen und aus Kostengründen nachteilig. Außerdem ist problematisch, daß beim Entfernen des Lösungsmittels sich Reste davon an Stellen niederschlagen können, wo dies nicht erwünscht ist, beispielsweise an Kontaktstellen. Dies würde Löt- oder Bondvorgänge nachteilig beeinflussen.

Auch das Entfernen der Passivierungsschicht mittels eines Sauerstoffplasmas ist kostenaufwendig. Auch wenn die Passivierungsschicht auf dem Wafer verbleiben kann, so muß sie doch partiell entfernt werden, um die Bondpats freizulegen. Dazu ist dann aber ein Photolithographieschritt erforderlich, was einen entsprechenden Zusatzaufwand erfordert.

Es sind auch Verfahren bekannt, bei denen Wafer einseitig geätzt werden können, ohne daß die nicht zu ätzende Seite mit einer Passivierungsschicht abgedeckt wird. Beispielsweise kann dies mit sogenannten Ätzdosen erfolgen, die einen Wafer einseitig dichtend umschließen. Der erforderliche Abdichtdruck belastet den Wafer mechanisch, so daß gerade bei Waferstrukturen mit dünnen Bereichen die Gefahr besteht, daß der Wafer zerbricht. Ätzmaschinen für dieses einseitige Ätzen sind teuer und es wird auch aus technischen Gründen vermieden, diese zu nutzen.

Aus der US 4,891,334 ist ein Verfahren bekannt, bei dem die Bauelementseite einer Halbleiterscheibe mit einem Schutzfilm mit einem Novolak-Harz abgedeckt wird. Anschließend wird die nicht von einem Schutzfilm abgedeckt, gegenüberliegende Seite der Halbleiterscheibe bearbeitet, um die Dicke der Halbleiterscheibe zu reduzieren. Danach wird der Schutzfilm mit Hilfe eines Lösungsmittels entfernt.

Aufgabe der vorliegenden Erfindung ist es, ein Verfahren zur einfachen Passivierung eines Waferbereiches oder einer Waferseite gegen Ätzlösungen anzugeben, bei dem die Nachteile des Standes der Technik vermieden werden und wobei insbesondere umweltschädliche und/oder teure Verfahren und Mittel vermieden werden.

Zur Lösung dieser Aufgabe wird vorgeschlagen, daß zumindest in einem äußeren Randbereich des Wafers eine Haftzone für die Passivierungsschicht geschaffen wird, die mit dem für die Passivierungsschicht verwendeten Material eine dichtende, insbesondere chemische Verbindung eingeht und dass die Passivierungsschicht nach dem Ätzen zumindest in dem außerhalb der Haftzonen liegenden Bereich mechanisch entfernt wird.

Durch die an vorbestimmten Stellen geschaffenen Haftzonen erfolgt in diesen beim Aufbringen der Passivierungs- oder Schutzschicht ein dichtendes, haltbares Verbinden, insbesondere durch die in diesen Haftbereichen erfolgende chemische Verbindung zwischen Haftzone und Passivierungsschicht, während die übrigen, von der Passivierungsschicht überdeckten Bereiche eine soweit verminderte Anhaftung an der Passivierungsschicht aufweisen, daß ein späteres Entfernen der Passivierungsschicht mit geringem Aufwand und insbesondere ohne Lösungsmittel möglich ist.

Während eine nur im Randbereich des Wafers vorgesehene, umlaufende Haftzone insbesondere bei Wafern mit geringem Durchmesser genügen kann, ist es bei größerflächigen Wafern zweckmäßig, auch innerhalb der von der Passivierungsschicht überdeckten Fläche Haftzonen vorzusehen, um die Passivierungsschicht zusätzlich zu stabilisieren.

Außer im äußeren Randbereich des Wafers können nach einer Ausgestaltung der Erfindung insbesondere im Verlauf der Wafer-Vorderseite, außerhalb der aktiven Chipflächen, weitere Haftzonen in einem die jeweiligen Chipsysteme umgrenzenden Bereich geschaffen werden.
Dadurch ist einerseits die zusätzliche Stabilisierung der Passivierungsschicht realisiert und außerdem können so auch Teilbereiche einer Waferseite durch eine Passivierungsschicht geschützt werden.

Eine bevorzugte Anwendung ist in Verbindung mit einem Rückseitenätzen eines Wafers, zum Beispiel zur Herstellung von Drucksensoren, vorgesehen. Dabei wird die die Chipsysteme aufweisende Wafer-Vorderseits mit der Passivierungsschicht abgedeckt.

Eine unabhängige Lösung, um dies erfindungsgemäß zu realisieren sieht vor, daß außerhalb der aktiven Chipfläche, in den die jeweiligen Chipsysteme umgrenzenden Bereichen Haftzonen für die Passivierungsschicht geschaffen werden, die mit dem für die Passivierungsschicht verwendeten Material eine dichtende, insbesondere chemische Verbindung eingehen und dass die Passivierungsschicht nach dem Rückseitenätzen zumindest in dem außerhalb der Haftzonen liegenden Bereich mechanisch entfernt wird.

Bei diesem Verfahren sind alle aktiven Chipflächen einzeln durch Haftzonen umgrenzt. Bei diesen Haftzonen bildet sich beim Aufbringen der Passivierungsschicht eine dichtende Verbindung, so daß alle Chips gut geschützt sind und die Passivierungsschicht durch die vielen Haftstellen stabil mit dem Wafer verbunden ist.

Zweckmäßigerweise werden die Haftzonen im Trennbereich zwischen den einzelnen Chips geschaffen, vorzugsweise durch Schichtabtragen bis auf die Substratschicht. Die Trennbereiche werden somit gleichzeitig als Haftzonen verwendet und es ist dadurch keine zusätzliche Chipfläche erforderlich.

Vorteilhaft ist es dabei, wenn die Haftzonen im Trennbereich in einer größeren Breite als die Breite des Sägeschnittes zum Zerteilen des Wafers eingebracht werden. Nach dem Entfernen der Passivierungsschicht bleiben in den Haftzonen Reste davon hängen, die beim Zerteilen des Wafers durch den Sägeschnitt nur zum Teil entfernt werden. Die neben der Sägespur anhaftenden Reste der Passivierungsschicht, die in diesem Zustand technisch nicht stören, können zur Originalitäts- und Herkunftssicherung dienen.

Vorzugsweise wird als Passivierungsschicht ein Edelmetall, zum Beispiel Palladium, gegebenenfalls mit einer zusätzlichen äußeren Schutzschicht, zum Beispiel aus Gold auf die zu schützenden Bereiche aufgebracht.
Eine Passivierungsschicht aus Edelmetall geht mit Silizium eine chemische Verbindung ein und haftet dadurch besonders gut im Bereich der vorgesehenen Haftzonen. Falls ein gegenüber dem Edelmetall, zum Beispiel Palladium, aggressives Ätzmittel verwendet werden muß, kann die Edelmetallschicht außen noch mit einer gegenüber dem Ätzmittel resistenten Schutzschicht zum Beispiel aus Gold versehen sein.

Aus der DE 196 41 777 A1 ist es zwar bekannt, eine Metallschicht aus Palladium auf eine MOS-Anordnung aufzubringen. Diese Metallschicht dient jedoch zur Bildung von Metallelektroden beziehungsweise Bondpads, also aktiven beziehungsweise bestimmungsgemäßen Bereichen, während der außerhalb der Metallelektroden und Bondpads befindliche, eigentlich unerwünschte Bereich der Metallschicht keine technische Funktion hat und deshalb nach dem Herstellen der Metallelektroden und Bondpads entfernt wird.

Eine Ausgestaltung der Erfindung sieht vor, daß die Haftzonen beim Strukturieren der Standard-Chip-Passivierung geschaffen werden, insbesondere durch Entfernen einer Oxydschicht. Dabei können die Haftzonen gleichzeitig mit dem Freiätzen von vorhandenen Bondpads freigelegt werden. Die Ätzung stoppt auf den insbesondere aus Aluminium bestehenden Bondpads, während sie im Bereich der vorgesehenen Haftzonen weiter bis auf das Silizium des Substrates geht.
Es besteht aber auch die Möglichkeit, dass mit dem Aufbringen der Passivierungsschicht gleichzeitig Bondpads oder dergleichen metallische Kontaktstellen gebildet werden. In solchen Kontaktstellenbereichen ist als Untergrund in der Regel Polysilizium vorhanden, das mit der Passivierungsschicht aus Metall, vorzugsweise Palladium, eine gute Haftverbindung eingeht, so daß in diesem Fall auch die Kontaktstellenbereiche Haftzonen bilden.
Wird die Passivierungsschicht entfernt, so bleibt sie in den Haftzonen erhalten und bildet bei den vorerwähnten Kontaktstellen metallische Bondpads.

Erwähnt sei noch, daß zumindest die Haftzonen im Bereich der Sägespuren auch durch mechanisches Abtragen der dort befindlichen Oxydschicht geschaffen werden können.

Die Passivierungsschicht kann nach dem Ätzen in nicht abgedeckten Bereichen, insbesondere nach einem Rückseitenätzen von der Waferoberfläche entfernt werden, wobei anschließend der Wafer in den vorzugsweise Haftzonen bildenden Trennbereichen zerteilt wird. Es besteht aber auch die Möglichkeit, daß die Passivierungsschicht nach dem Rückseitenätzen gleichzeitig mit dem Zerteilen des Wafers von der Waferoberfläche entfernt wird.

Das Entfernen der Passivierungsschicht erfolgt mechanisch, indem sie durch einen Flüssigkeitsstrom und/oder durch einen Gasstrom und/oder durch Ultraschallbeaufschlagung von der Waferoberfläche beziehungsweise den Chipoberflächen entfernt wird.
Diese mechanischen Trennverfahren ermöglichen ein lösungsmittelfreies, umweltschonendes Entfernen, wobei die Passivierungsschicht aus den außerhalb der Haftzonen liegenden Bereichen zuverlässig entfernt wird und dabei eine Trennung von den besser anhaftenden Passivierungsschicht-Bereichen in den Haftzonen erfolgt.
Wird das Entfernen der Passivierungsschicht beim Zerteilen des Wafers vorgenommen, so kann die Passivierungsschicht durch die zum Sägen zugeführte Flüssigkeit bei entsprechendem Druck entfernt werden. Dies kann aber auch unter Zuhilfenahme von Zusatzmaßnahmen, beispielsweise Druckluft, Ultraschall und dergleichen erfolgen.

Zusätzliche Ausgestaltungen der Erfindung sind in den weiteren Unteransprüchen aufgeführt. Nachstehend ist die Erfindung mit ihren wesentlichen Einzelheiten anhand der Zeichnungen näher erläutert.

Es zeigt etwas schematisiert:
- Fig.1: einen Waferabschnitt mit mehreren Chipbereichen,
- Fig.2: eine Darstellung etwa wie Fig.1, hier jedoch mit einer auf der Oberseite aufgetragenen Passivierungsschicht und rückseitig eingeätzten Vertiefungen und
- Fig.3: eine Darstellung einzelner Chips nach dem Entfernen der Passivierungsschicht und dem Vereinzeln.

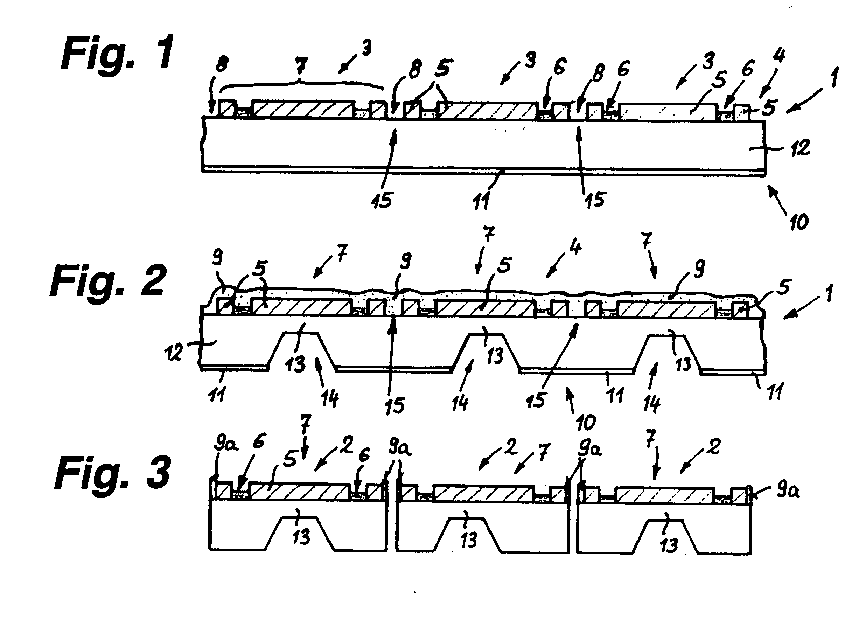

Die Figuren 1 bis 3 zeigen drei Phasen eines Verfahrens zum Herstellen von Drucksensoren. In Fig.1 ist dabei ein Abschnitt eines Wafers 1 mit drei jeweils zu einem späteren Drucksensor 2 (Fig.3) gehörenden Halbleiteranordnungen 3 gezeigt, von denen in den Figuren nur die auf der Wafervorderseite 4 aufgebrachte Oxydschicht 5 sowie mit eindiffundierten Widerständen in Kontakt stehende Bondpads 6 dargestellt sind.

Neben den jeweils einen Chip 7 bildenden Halbleiteranordnungen sind Haftzonen 8 vorgesehen, in denen das Basismaterial des Wafers, in der Regel Silizium, freigelegt ist. Diese Haftzonen 8 können gleichzeitig mit dem Freiätzen der Bondpads 6 geschaffen werden, indem die Maske für die Bondpads 6 gleichzeitig auch zum Herstellen der Haftzonen 8 ausgebildet ist. Während des Ätzprozesses wird die Oxydschicht 5 im Bereich der Bondpads 6 bis auf die Metallisierung, meist aus Aluminium, freigeätzt und stoppt dort, während im Bereich der Haftzonen 8 die Oxydschicht 5 bis auf das Substratmaterial des Wafers weggeätzt wird.

Wie in Fig.2 erkennbar, wird anschließend diese Wafervorderseite 4 mit einer Passivierungsschicht 9 abgedeckt, die insbesondere aus einem Edelmetall besteht. Die Passivierungsschicht 9 geht mit dem Substratmaterial des Wafers bei den Haftzonen 8 eine gut haftende Verbindung ein, während sich in den übrigen, überdeckten Bereichen der Waferoberfläche keine haltbare Verbindung einstellt.

Die Rückseite 10 des Wafers 1 ist mit einer Ätzmaskierung 11 versehen, um in vorgesehenen Membranbereichen 13 Vertiefungen 14 in das Wafersubstrat 12 ätzen zu können (Fig.2). Während dieses Ätzvorganges ist die Wafervorderseite 4 durch die Passivierungsschicht 9 geschützt.

In einem nächsten Verfahrensschritt nach dem Ätzen wird die Passivierungsschicht 9 entfernt, damit die Bondpads 6 zum Anbringen von Anschlüssen frei zugänglich sind. Da die Passivierungsschicht 9 nur in den Haftzonen 8 eine haltbare Verbindung mit der Wafervorderseite 4 eingegangen ist, können die übrigen, insbesondere die einzelnen Chips 7 überdeckenden Teile der Passivierungsschicht 9 leicht entfernt werden. In diesen Bereichen ergeben sich nur geringe Hafteigenschaften, da die metallische Passivierungsschicht 9 an der Oxydschicht 5 und auch an den Aluminium-Bondpads 6 keine chemische Verbindung eingeht. Es besteht dadurch die Möglichkeit, diese Teile der Passivierungsschicht 9 durch mechanische Einwirkung zu entfernen, was beispielsweise durch Abspülen mit Wasser erfolgen kann.
Um das Ablösen der Passivierungsschicht 9 zu begünstigen, kann als mechanische Einwirkung auch eine Ultraschallbeaufschlagung vorgesehen sein, wobei unter Zurhilfenahme von Wasser eine sichere und gleichzeitig schonende Ablösung der Passivierungsschicht 9 möglich ist.
Um das Ablösen der Passivierungsschicht 9 zu begünstigen, kann diese vor dem Entfernen mit einem wasserstoffhaltigen Gas behandelt werden.

Die außerhalb der aktiven Chipfläche vorgesehenen Haftzonen 8 sind zweckmäßigerweise so positioniert, daß sie in den Trennbereichen 15 liegen, in denen der Wafer durchtrennt und die einzelnen Chips vereinzelt werden. In diesen Bereichen anhaftenden Reste der Passivierungsschicht 9 werden dabei entweder durch den Sägeschnitt entfernt, oder aber, wenn die Sägespur schmaler ist als der jeweilige Haftzonenbereich 8, bleiben beidseitig der Sägespur kleine Reste 9a der Passivierungsschicht 9 hängen, wie dies gut in Fig. 3 erkennbar ist. Damit ist eine Originalitäts- und Herkunftssicherung möglich und selbst wenn diese Reste abgeätzt werden würden, ließe sich an den dann vorhandenen Ätzspuren nachweisen, daß nach dem erfindungsgemäßen Verfahren gearbeitet wurde. Die Reste 9a der Passivierungsschicht bilden keine Funktionteile und beeinträchtigen somit die technische Funktion des Chips nicht.

Das Entfernen der Passivierungsschicht 9 kann in der in Fig.2 gezeigten Herstellungsphase erfolgen oder gegebenenfalls auch gleichzeitig mit dem Zerteilen des Wafers 1 in die einzelnen Chips 7.

## Patentansprüche

1. Verfahren zum Herstellen einer Halbleiteranordnung (3), wobei ein Wafer (1) mit einer Vielzahl von Chips (7) bildenden Halbleiteranordnungen hergestellt und der Wafer danach zerteilt und dadurch die Halbleiteranordnungen vereinzelt werden, wobei zumindest ein Bereich einer Waferseite während des Ätzens des übrigen Waferbereichs mittels einer Passivierungsschicht (9) abgedeckt wird und wobei nach dem Ätzen die Passivierungsschicht zumindest teilweise entfernt wird, **dadurch gekennzeichnet, dass** zumindest in einem äußeren Randbereich des Wafers (1) eine Haftzone (8) für die Passivierungsschicht (9) geschaffen wird, die mit dem für die Passivierungsschicht (9) verwendeten Material eine dichtende und gut haftende Verbindung eingeht und dass die Passivierungsschicht (9) nach dem Ätzen zumindest in den außerhalb der Haftzonen (8) liegenden Bereich mechanisch entfernt wird.

2. Verfahren nach Anspruch 1, **dadurch gekennzeichnet, dass** zusätzlich zu der im äußeren Randbereich des Wafers (1) geschaffenen Haftzone (8) für die Passivierungsschicht (9), insbesondere im Verlauf der Wafer-Vorderseite, außerhalb der aktiven Chipfläche, weitere Haftzonen (8) insbesondere in einem die jeweiligen Chipsysteme umgrenzenden Bereich geschaffen werden.

3. Verfahren zum Herstellen einer Halbleiteranordnung (3), wobei ein Wafer (1) mit einer Vielzahl von Chips (7) bildenden Halbleiteranordnungen hergestellt und der Wafer danach zerteilt und dadurch die Halbleiteranordnungen vereinzelt werden, wobei zumindest ein Bereich einer Waferseite während des Ätzens des übrigen Waferbereichs mittels einer Passivierungsschicht (9) abgedeckt wird und wobei nach dem Ätzen die Passivierungsschicht zumindest teilweise entfernt wird, **dadurch gekennzeichnet, dass** die das Chipsystem aufweisende Vorderseite während eines Rückseitenätzens mittels der Passivierungsschicht (9) abgedeckt wird und dass in den die jeweiligen Chipsysteme umgrenzenden Bereichen Haftzonen (8) für die Passivierungsschicht (9) geschaffen werden, die mit dem für die Passivierungsschicht verwendeten Material eine dichtende Verbindung eingehen und dass die Passivierungsschicht (9) nach dem Rückseitenätzen zumindest in dem außerhalb der Haftzonen (8) liegenden Bereich mechanisch entfernt wird.

4. Verfahren nach Anspruch 3, bei dem Haftzonen (8) außerhalb der aktiven Chipflächen geschaffen werden.

5. Verfahren nach einem der Ansprüche 1 bis 4, **dadurch gekennzeichnet, dass** die Haftzonen (8) im Trennbereich (15) zwischen den einzelnen Chips (7) geschaffen werden, vorzugsweise durch Schichtabtragen bis auf die Substratschicht.

6. Verfahren nach Anspruch 5, **dadurch gekennzeichnet, dass** die Haftzonen im Trennbereich (15) zwischen den einzelnen Chips (7) in einer größeren Breite als die Breite des Sägeschnittes zum Zerteilen des Wafers eingebracht werden.

7. Verfahren nach einem der Ansprüche 1 bis 6, **dadurch gekennzeichnet, dass** als Passivierungsschicht (9) ein Edelmetall, zum Beispiel aus Palladium gegebenenfalls mit einer zusätzlichen, äußeren Schutzschicht, zum Beispiel aus Gold auf den zu schützenden Waferbereich aufgebracht wird.

8. Verfahren nach einem der Ansprüche 1 bis 7, **dadurch gekennzeichnet, dass** die Haftzonen (8) beim Strukturieren der Standard-Chippassivierung geschaffen werden, insbesondere durch Entfernen einer Oxidschicht (5).

9. Verfahren nach einem der Ansprüche 1 bis 8, **dadurch gekennzeichnet, dass** die Passivierungsschicht (9) aufgedampft oder durch galvanisches, insbesondere durch stromloses galvanisches Abscheiden eines Metalls aufgebracht wird.

10. Verfahren nach einem der Ansprüche 1 bis 9, **dadurch gekennzeichnet, dass** mit dem Aufbringen der Passivierungsschicht (9) gleichzeitig Bondpats (6) und dergleichen Kontaktstellen gebildet werden.

11. Verfahren nach einem der Ansprüche 1 bis 10, **dadurch gekennzeichnet, dass** der beim Aufbringen der Passivierungsschicht (9) abgedeckte Bereich, der Passivierungsschicht gegenüber schlechtere Hafteigenschaften als das in den Haftzonen (8) vorhandene Material hat.

12. Verfahren nach einem der Ansprüche 1 bis 11, **dadurch gekennzeichnet, dass** die Passivierungsschicht (9) nach dem Ätzen in einer oder mehreren nicht von der Passivierungsschicht abgedeckten Bereichen, insbesondere nach einem Rückseitenätzen, von der Waferoberfläche entfernt wird und dass anschließend der Wafer in den Haftzonen (8) bildenden Trennbereichen (15) zerteilt wird.

13. Verfahren nach einem der Ansprüche 1 bis 12, **dadurch gekennzeichnet, dass** die Passivierungsschicht (9) nach dem Rückseitenätzen gleichzeitig mit dem Zerteilen des Wafers von der Waferoberfläche entfernt wird.

14. Verfahren nach einem der Ansprüche 1 bis 13, **dadurch gekennzeichnet, dass** die Passivierungsschicht (9) mechanisch durch einen Flüssigkeitsstrom und/oder durch einen Gasstrom und/oder durch Ultraschallbeaufschlagung von der Waferoberfläche beziehungsweise den Chipoberflächen entfernt wird.

15. Verfahren nach einem der Ansprüche 1 bis 14, **dadurch gekennzeichnet, dass** die Passivierungsschicht (9) vor dem Entfernen mit einem wasserstoffhaltigen Gas behandelt wird.

16. Verfahren nach einem der Ansprüche 1 bis 15, **dadurch gekennzeichnet, dass** die außerhalb der Haftzonen (8) liegenden Bereiche der Chips vor dem Aufbringen der Passivierungsschicht (9) mit einer Beschichtung vorzugsweise aus einem Oxid, insbesondere Siliziumoxid (5) versehen werden, die schlechtere Hafteigenschaften als das in den Haftzonen (8) befindliche Material aufweist.

17. Verfahren nach einem der Ansprüche 1 bis 16, **dadurch gekennzeichnet, dass** die dichtende Verbindung eine chemische Verbindung ist.

## Claims

1. A method for the manufacture of a semiconductor assembly (3), whereby semiconductor assemblies forming a wafer (1) with a plurality of chips (7) is produced and the wafer is subsequently severed and the semiconductor assemblies are separated thereby, whereby at least one region of one side of a wafer is covered by means of a passivation layer (9) during the etching of the remaining wafer region and whereby after etching the passivation layer is at least partially removed, **characterised in that** at least in an outer edge region of the wafer (1) an adhesive zone (8) for the passivation layer (9) is created, which enters into a tight and good adhesive bond with the material used for the passivation layer (9) and **in that** after etching the passivation layer (9) is mechanically removed at least in the region lying outside the adhesive zones (8).

2. A method according to Claim 1,
**characterised in that** in addition to the adhesive zone (8) for the passivation layer (9) created in the outer edge region of the wafer (1), in particular in the course of the front side of the wafer, outside the active chip area, further adhesive zones (8) are created, in particular in a region surrounding the respective chip systems.

3. A method for the manufacture of a semiconductor assembly (3), whereby semiconductor assemblies forming a wafer (1) with a plurality of chips are manufactured and the wafer is subsequently severed and the semiconductor assemblies are separated thereby, whereby at least one region of one side of the wafer is covered by means of a passivation layer (9) during the etching of the remaining wafer region and whereby after etching the passivation layer is at least partially removed,
**characterised in that** the front side comprising the chip system is covered during reverse etching by means of the passivation layer (9)
and **in that** in the regions bordering the respective chip systems, adhesive zones (8) for the passivation layer (9) are created, which enter into a tight bond with the material used for the passivation layer
and **in that** after reverse etching the passivation layer (9) is mechanically removed at least in the region lying outside the adhesive zones (8).

4. A method according to Claim 3, in which adhesive zones (8) are created outside the active chip areas.

5. A method according to one of Claims 1 to 4,
**characterised in that** the adhesive zones (8) are created in the separating region (15) between the individual chips (7), preferably by layer removal right down to the substrate layer.

6. A method according to Claim 5,
**characterised in that** the adhesive zones are inserted in the separating region (15) between the individual chips (7) in a greater width than the width of the saw notch for severing the wafer.

7. A method according to one of Claims 1 to 6,
**characterised in that** a precious metal, for example of palladium possibly with an additional, outer protective layer, for example made of gold, is applied as the passivation layer (9) to the wafer region to be protected.

8. A method according to one of Claims 1 to 7,
**characterised in that** the adhesive zones (8) are created during the structuring of the standard chip passivation, in particular by the removal of an oxide layer (5).

9. A method according to one of Claims 1 to 8,
**characterised in that** the passivation layer (9) is vapour-deposited or applied by the electrolytic, in particular by currentless, electrodeposition, of a metal.

10. A method according to one of Claims 1 to 9,
**characterised in that** bondpads (6) and similar contact points are simultaneously formed with the application of the passivation layer (9).

11. A method according to one of Claims 1 to 10,
**characterised in that** the region covered during the application of the passivation layer (9) has worse adhesive properties compared to the passivation layer than the material provided in the adhesive zones (8).

12. A method according to one of Claims 1 to 11,
**characterised in that** the passivation layer (9) is removed from the wafer surface after etching in one or more regions not covered by the passivation layer, in particular after reverse etching,
and **in that** subsequently the wafer is severed in the separating regions (15) forming adhesive zones (8).

13. A method according to one of Claims 1 to 12,
**characterised in that** after reverse etching the passivation layer (9) is removed from the wafer surface simultaneously with the severing of the wafer.

14. A method according to one of Claims 1 to 13,
**characterised in that** the passivation layer is mechanically removed by a stream of liquid and/or by a stream of gas and/or by ultrasonic impingement of the wafer surface or the chip surfaces.

15. A method according to one of Claims 1 to 14,
**characterised in that** passivation layer (9) is treated prior to removal with a hydrogenous gas.

16. A method according to one of Claims 1 to 15,
**characterised in that** prior to the application of the passivation layer (9), the regions of the chips lying outside the adhesive zones are provided with a coating preferably of an oxide, in particular silicon oxide (5), which has worse adhesive properties than the material situated in the adhesive zones (8).

17. A method according to one of Claims 1 to 16,
**characterised in that** the tight bond is a chemical bond.

## Revendications

1. Procédé de fabrication d'un dispositif à semi-conducteur (3), selon lequel on produit une tranche (1) présentant une pluralité de dispositifs à semi-conducteur formant des puces (7), puis on morcelle la tranche, en individualisant ainsi les dispositifs à semi-conducteur, et on recouvre au moins une face de la tranche au moyen d'une couche de passivation (9) pendant la gravure de la région restante de la tranche, puis on enlève au moins partiellement la couche de passivation après la gravure,
**caractérisé en ce que**
dans au moins une région marginale extérieure de la tranche (1), on crée une zone d'adhérence (8) pour la couche de passivation (9), zone qui entre dans une liaison de formation d'un joint étanche et bien adhérente avec la matière utilisée pour la couche de passivation (9) et qu'après la gravure, on enlève mécaniquement la couche de passivation (9), au moins dans la région située à l'extérieur des zones d'adhérence (8).

2. Procédé selon la revendication 1,
**caractérisé en ce qu'**
outre la zone d'adhérence (8) créée pour la couche de passivation (9) dans la région marginale extérieure de la tranche (1), en particulier dans le profil de la face avant de la tranche, en dehors de la surface active de la puce, on crée d'autres zones d'adhérence (8), en particulier dans une région qui entoure les systèmes de puces concernés.

3. Procédé de fabrication d'un dispositif à semi-conducteur (3), selon lequel on produit une tranche (1) présentant une pluralité de dispositifs à semi-conducteur formant des puces (7) puis on morcelle ensuite la tranche, en individualisant ainsi les dispositifs à semi-conducteur et on recouvre au moins une face de la tranche au moyen d'une couche de passivation (9) pendant la gravure de la région restante de la tranche, puis on enlève au moins partiellement la couche de passivation après la gravure,
**caractérisé en ce qu'**
on recouvre la face avant, qui présente le système de puces au moyen de la couche de passivation (9) pendant une gravure de la face arrière et, dans les régions qui entourent les systèmes de puces considérés, on crée des zones d'adhérence (8) pour la couche de passivation (9), qui entrent en liaison de formation d'un joint étanche avec la matière utilisée pour la couche de passivation et on enlève mécaniquement la couche de passivation (9), au moins dans la région située à l'extérieur des zones d'adhérence (8) après la gravure de la face arrière.

4. Procédé selon la revendication 3,
selon lequel on crée des zones d'adhérence (8) en dehors des surfaces actives des puces.

5. Procédé selon une des revendications 1 à 4,
**caractérisé en ce qu'**
on crée les zones d'adhérence (8) dans la région de séparation (15) entre les différentes puces (7), de préférence par enlèvement de couches jusqu'à la couche de substrat.

6. Procédé selon la revendication 5,
**caractérisé en ce qu'**
on forme les zones d'adhérence dans la région de séparation (15) entre les différentes puces (7), avec une largeur supérieure à la largeur du trait de soie servant à morceler la tranche.

7. Procédé selon une des revendications 1 à 6,
**caractérisé en ce que**
comme couche de passivation (9) sur la région de la tranche qu'il s'agit de protéger, on dépose un métal précieux, par exemple du palladium, éventuellement recouvert d'une couche protectrice extérieure supplémentaire en or par exemple.

8. Procédé selon une des revendications 1 à 7,
**caractérisé en ce qu'**
on crée les zones d'adhérence (8) lors de la structuration de la passivation standard des puces, en particulier par enlèvement d'une couche d'oxyde (5).

9. Procédé selon une des revendications 1 à 8,
**caractérisé en ce qu'**
on vaporise ou dépose la couche de passivation (9) par précipitation galvanique d'un métal, en particulier par précipitation galvanique sans courant.

10. Procédé selon une des revendications 1 à 9,
**caractérisé en ce qu'**
on forme simultanément au dépôt de la couche de passivation (9), des plots de soudage (6) et des points de contact analogues.

11. Procédé selon une des revendications 1 à 10,
**caractérisé en ce que**
la région recouverte lors du dépôt de la couche de passivation (9) possède de plus mauvaises propriétés d'adhérence vis-à-vis de la couche de passivation que la matière présente dans les zones d'adhérence (8).

12. Procédé selon une des revendications 1 à 11,
**caractérisé en ce qu'**
après la gravure, on enlève la couche de passivation (9) de la surface de la tranche dans une ou plusieurs régions non recouvertes par la couche de passivation, en particulier après une gravure de la face arrière, puis on morcelle la tranche dans les régions de séparation (15) formant les zones d'adhérence (8).

13. Procédé selon une des revendications 1 à 12,
**caractérisé en ce qu'**
après la gravure de la face arrière, on enlève la couche de passivation (9) de la surface de la tranche en même temps qu'on découpe la tranche.

14. Procédé selon une des revendications 1 à 13,
**caractérisé en ce que**
la couche de passivation (9) est enlevée mécaniquement de la surface de la tranche ou des surfaces des puces par un courant de liquide et/ou par un courant de gaz et/ou par un traitement par les ultrasons.

15. Procédé selon une des revendications 1 à 14,
**caractérisé en ce qu'**
avant d'enlever la couche de passivation (9), on la traite avec un gaz contenant de l'hydrogène.

16. Procédé selon une des revendications 1 à 15,
**caractérisé en ce qu'**
avant le dépôt de la couche de passivation (9), on munit les régions des puces qui se trouvent en dehors des zones d'adhérence (8) d'un revêtement, de préférence un oxyde, en particulier de l'oxyde de silicium (5), qui possède de plus mauvaises propriétés d'adhérence que la matière se trouvant dans les zones d'adhérence (8).

17. Procédé selon une des revendications 1 à 16,
**caractérisé en ce que**
la liaison de formation d'un joint étanche est une liaison chimique.
